# EUROPEAN PATENT SPECIFICATION

(11) **EP 2 866 268 B1**
(45) Date of publication and mention of the grant of the patent: **22.03.2017**
(21) Application number: 13382431.8
(22) Date of filing: 28.10.2013
(51) Int. Cl.: H01L 31/054, H01L 31/05, H01L 31/042, H02S 40/22, H02S 20/10

(54) **Photovoltaic units and structures**
Photovoltaische Einheiten und Strukturen
Structures et unités photovoltaïques

(43) Date of publication of application: 29.04.2015
(73) Proprietor: Repsol, S.A., 28045 Madrid (ES); Onyx Solar Energy, S.L., 05004 Avila (ES)
(72) Inventor: Pérez Lepe, Antonio, 28935 Móstolez (ES); Izquierdo Rodríguez, María Ángeles, 28935 Móstoles (ES); Hernández Rueda, Silvia, 28935 Móstoles (ES); Prieto Acedo, Óscar, 28935 Móstoles (ES); Del Cano, Teodosio, 05004 Ávila (ES); Casado, Leonardo, 05004 Ávila (ES); Beltrán, Álvaro, 05004 Ávila (ES); Valencia, Daniel, 05004 Ávila (ES); López González, Eduardo, 47003 Valladolid (ES)
(74) Representative: ZBM Patents - Zea, Barlocci & Markvardsen

(56) References cited:
- WO-A2-2010/007256
- US-A- 5 716 442
- US-A1- 2012 097 212
- US-B1- 8 068 282

## Description

The present disclosure relates to energy conversion and more specifically to photovoltaic units and structures.

### BACKGROUND ART

Between the years 2000 and 2030, it is estimated that the demand in fossil fuels will increase about 70%. The energy demand, the consumption of raw materials, the increase in emissions and the greenhouse effect, have made it necessary to consider solutions coming from renewable energy sources for the production of energy. Energy from water and air flows, biomass and sun are some of the most promising of such sources.

Additionally, today's electricity production is mostly based on large centralized facilities, such as fossil fuel (coal, gas powered), nuclear, large solar power plants or hydropower plants. These plants usually transmit electricity long distances, which is linked to energy losses. A more distributed or decentralized generation of electricity may allow collection of energy from many sources and can potentially improve the security of supply and may lead to less energy being lost.

There is a need to provide apparatus suitable for distributed and renewable energy generation.

Photovoltaic cells are electrical devices that convert the energy of light directly into electricity by the photovoltaic effect. They are typically arranged in modules that comprise a plurality of photovoltaic cells. Such modules are called solar panels. Arrays of panels are typically used to generate enough electricity that would be meaningful to store in batteries or to directly power electricity consuming devices. However, such arrays may consume a lot of space, which cannot otherwise be used. For example, it is known to place large arrays of photovoltaic panels in fields or to place a single panel or a smaller array of panels on top of buildings.

US 2012 097212 discloses photovoltaic distributed upon an inner surface of a perimeter of a tubular structure. The tubular structure may be installed in the roof of a habitable or uninhabitable structure to provide low-profile solar energy.

US20050199282 discloses an integrated solar power system that provides electricity to external electrical devices. It has a trafficable surface formed by a plurality of roadway panels arranged with respect to each other. Each roadway panel has a solar energy collector, a layer of translucent and protective material covering the solar energy collector, the material being sufficiently translucent to allow passage of light therethrough for absorption of light by said solar energy collector.

However, these roadway panels may be relatively expensive and/or unable to withstand high loads. For example, the roadway panels may possibly be used for pedestrian areas or bicycle lanes. But to make the roadway panels strong and resistant enough for highways and able to withstand heavy traffic, such as trucks or lorries, would hardly be feasible or at the very least would be very expensive.

It is an object of the present disclosure to provide photovoltaic units that at least partially resolve the aforementioned problems.

### SUMMARY OF THE INVENTION

In a first aspect, a photovoltaic unit according to claim 1 is disclosed. The photovoltaic unit comprises a housing having a cylindrical wall arranged around a central axis of the housing, and a translucent closing element at a first end of the cylindrical wall. The photovoltaic unit further comprises a photovoltaic cell arranged along said central axis. The photovoltaic cell comprises an anode, a cathode and photoactive material and electrical output wires are connected to the anode and to the cathode. An inner surface of the cylindrical wall is reflective to sun light.

The photovoltaic unit according to the first aspect may be manufactured at low cost, is relatively easy to assemble and may be easily integrated in all sorts of support structures, such as roads, pavements or e.g. building walls.

In some embodiments, the translucent closing element may be a substantially flat circular disc. Thus, it may be easily embedded in structures. Optionally, the closing element may be transparent.

In accordance with the invention, the photovoltaic unit further comprises a second closing element at a second end of the cylindrical wall which is conical. The second closing element is at least partially reflective to sun light. This may increase the amount of sun light that is reflected to the photovoltaic cell.

In accordance with the invention, the photovoltaic cell is substantially cylindrical. An aspect of the combination of an inner reflective surface of a cylinder and a substantially cylindrical photovoltaic cell disposed along a central axis of the cylinder is that substantially all rays of sun light entering the photovoltaic unit may be captured by the photovoltaic cell.

In some embodiments the photovoltaic cell may be a thin film solar cell. Thin film solar cells may acquire any desired shape. This is advantageous as the solar cell may easily be formed as a cylinder and, thus acquire a shape that may maximize the sun light that reaches its surface either received directly or reflected from the inner surface of the cylindrical wall. Furthermore, they are of low cost to manufacture.

In some embodiments, the photovoltaic cells may be dye-sensitized solar cells, organic photovoltaic cells or crystalline silicon cells. One skilled in the art may appreciate that any type of solar cell that may assume a cylindrical shape may be appropriate for the photovoltaic cells according to the invention.

In general, cylindrical photovoltaic cells may be made e.g. by wet deposition on a cylindrical substrate or alternatively by a deposition on a plane substrate and subsequently rolling the substrate to form a cylinder. Different techniques for deposition may generally be used in examples of the present invention, including e.g. chemical vapor deposition, electrospray deposition, sputtering and co-evaporation.

In another aspect of the invention a photovoltaic structure is disclosed. The photovoltaic structure may comprise a support and one or more photovoltaic units as discussed above with reference to the first aspect.

In some embodiments, the support may have a substantially smooth external surface. Each photovoltaic unit of the structure may be arranged in such a way that the translucent closing element lies substantially flush with the flat external surface. This arrangement may have both aesthetic and functional benefits. The flush closing element may look like a window embedded in the support. Furthermore, as it may not protrude from the support, it has the benefit that it may be integrated and embedded in structures such as walls or paved grounds such as roads, where protrusion may be undesired, because it may e.g. cause bumps to passing vehicles.

In some embodiments, the support may be a paved structure. The photovoltaic units may be embedded in such a way with respect to the paved structure, to allow easy integration of the units to the structure and/or to maximize the collection of sun light by the photovoltaic cells. In some examples, the units' central axes may be substantially vertically arranged with respect to the road structure or they may be inclined so that they best correspond to a trajectory of the sun. Examples of paved structures may be roads, highways, parking areas, bicycle roads, public squares or roundabouts, and pavements and generally, any type of paved ground exposed to sun light and used by vehicles or pedestrians.

In some embodiments, the electrical power output wires of one or more of the photovoltaic units may be connected to a metal mesh in the paved structure. For example, when the paved structure is a road, the electricity may be produced in an internal area of the road and be transferred towards the periphery of the road and closer to electricity consumers such as e.g. road illumination systems or even houses.

In some embodiments, the support may be an exterior surface of a building, such as a wall or a roof. The photovoltaic units may be embedded in such a way as to facilitate integration with the exterior surface or to maximize efficiency. Therefore, the units' central axes may be either substantially perpendicularly arranged with respect to the exterior surface, which may be easier to integrate or placed with a certain inclination. The former arrangement facilitates integration in walls. For example, in a vertical wall, the units may be arranged substantially horizontally and in a horizontal root, the units may be arranged substantially vertically. However, based on the sun's trajectory, the orientation of the wall and the latitude of the building, the latter arrangement may maximize the average collection of sun light during a calendar year.

In some embodiments, the electrical power generated by the photovoltaic units may be accumulated for later use. In some examples, said accumulation may involve storing the energy in accumulators or batteries. For example, in the case when the units are placed in road structures, batteries may be placed along the side of the road, below or within road illumination systems, so that they may provide electricity to said systems during the night. In other embodiments the electrical power generated by the photovoltaic units may be used to power directly any type of electrical system that is located adjacent to the photovoltaic structure. For example, they may be used to power illumination systems or traffic lights or even be connected to the electrical grid.

Additional objects, advantages and features of embodiments of the invention will become apparent to those skilled in the art upon examination of the description, or may be learned by practice of the invention.

### BRIEF DESCRIPTION OF THE DRAWINGS

Particular embodiments of the present invention will be described in the following by way of non-limiting examples, with reference to the appended drawings, in which:
Figure 1 shows a longitudinal cross-section of a photovoltaic unit according to an embodiment;
Figure 2 shows a plan view of a photovoltaic structure according to an embodiment; and
Figure 3 shows a longitudinal cross-section of a photovoltaic structure according to another embodiment.

### DETAILED DESCRIPTION OF EMBODIMENTS

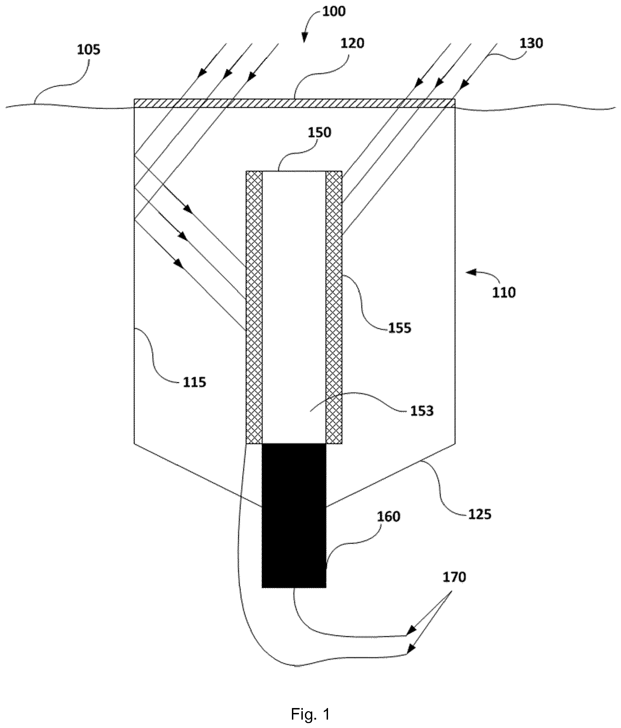

Figure 1 shows a cross section of a photovoltaic unit according to an embodiment. The photovoltaic unit 100 may be arranged inside a support structure 105. The support structure 105 may be any type of paved ground or way such as a road, a highway, a parking area, a bicycle road, a public square or a roundabout, a pavement and generally, any type of paved ground exposed to sun light and used by vehicles or pedestrians. It may be made of e.g. asphalt or cement concrete. However, any other type of material that is suitable to support photovoltaic unit 100 may be used in examples of the present invention.

The photovoltaic unit 100 comprises a housing 110 and a photovoltaic cell 150 arranged along a central axis of housing 100. The housing 110 may have a substantially cylindrical wall 115 arranged around the central axis of the housing 110. An inner surface of the cylindrical wall 115 is reflective to sun light 130. The cylindrical wall 115 may be made of a reflective material or it a reflective material coated or otherwise arranged on the inner surface of the wall.

A first end of the housing 110 may be closed with a translucent element 120. The translucent element 120 may be flat and in the form of a cylindrical disc. It should be made of a material that is translucent enough so that light 130 may pass through. In some examples, it may be substantially transparent.

The other end of the cylindrical wall 115 in this example is closed with a closing element 125. The closing element 125 may also be made of or coated with reflective material. Furthermore, in the example of Fig. 1, its internal shape is shown concave and in particular conical. Therefore, any sun light 130 falling on the closing element 125 may be reflected directly back onto the photovoltaic cell 150 or to the inner surface of the cylindrical wall 115 (and eventually onto the photovoltaic cell 150).

In the shown embodiment, the conical closing element may make its integration in a support structure easier, in particular in structures in which the photovoltaic unit may be inserted when the structure is in a soft or liquid/slurry state and is subsequently hardened, e.g. in the case of asphalt.

The photovoltaic cell 150 is also substantially cylindrical and comprises an anode 155, a cathode 160 and photoactive material so that any sun light falling on the cell may generate a voltage difference between the anode and the cathode. The sun light 130 may fall on the photoactive material either directly, through the translucent closing element 120 or indirectly, reflected by the reflective cylindrical wall 115 of the housing 110 or by the closing element 125.

The photovoltaic cell 150 may be a (flexible) thin film solar cell, a dye-sensitized solar cell, an organic photovoltaic cell or a crystalline silicon cell. These types of cells are relatively low cost to manufacture and may adopt a desired shape, such as the cylindrical shape used in the example of the photovoltaic unit 100.

A pair of electrical output wires 170 is shown connected at one end to the anode 155 and the cathode 160, respectively. At the other end they may be connected to a battery or to an electrical network (not shown).

During the day, sun light 130 may pass through the translucent element 120, as shown in Fig. 1. A portion of the photovoltaic cell 150 will be directly illuminated by sun light while another portion will be illuminated by sun light reflected from the reflective cylindrical wall 115. The photovoltaic cell 150 will convert a portion of the energy of the light received thereupon into electricity. More specifically, an electrical potential difference will be generated between the anode 155 and the cathode 160 of the photovoltaic cell. Energy that is converted in the photovoltaic cell may be used to power other electrical components or devices or it may be stored in e.g. batteries for future use.

Different techniques may be used for manufacturing the photovoltaic cell. And different materials and designs may be used for the anode, cathode and photoactive material. In an example, photoactive material may be applied to a cylindrical substrate 153, in particular using wet deposition. In another example, a deposition may be made on a plane substrate which is subsequently formed into a cylinder, e.g. by rolling.

In yet a further non-illustrated example, the relative position of the anode and cathode may be interchanged, i.e. the cathode may be arranged on the outside or on the outer surface of the photovoltaic cell (the rays of sun light thus have to pass through the cathode), whereas the anode is arranged in the interior of the photovoltaic cell.

In accordance with this design, the cost of manufacturing may be relatively small, which makes it suitable for a wide range of applications among which paved structures such as roads, pavements, bicycle lanes, parkings etc.

The whole unit should be strong enough so that it may support the loads, such as a vehicle or a person passing on top of it. The translucent element 120 is shown embedded in the support structure in such a way that it is substantially on the same level as the support structure. Therefore, any above passing vehicles or pedestrians will not feel a noticeable bump when crossing the support structure 110.

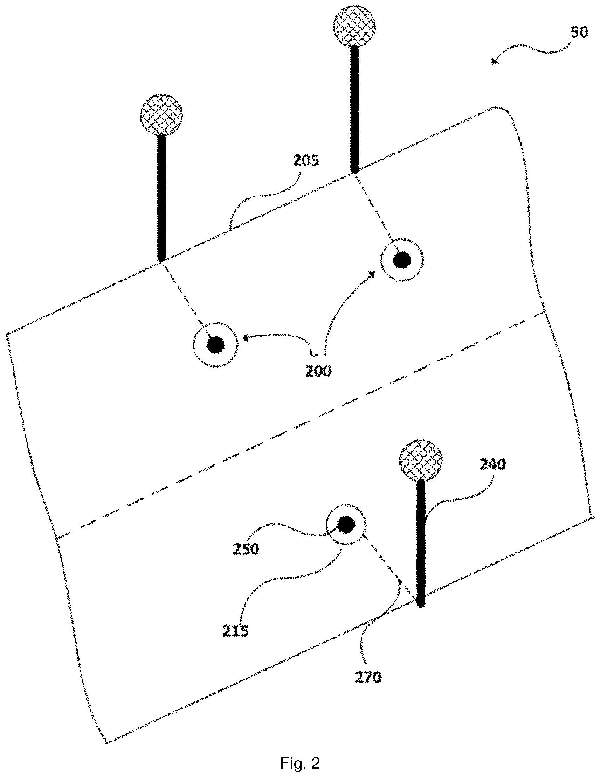

Fig. 2 shows a plan view of a photovoltaic structure according to an embodiment. The photovoltaic structure 50 comprises a plurality of photovoltaic units 200 and a support structure 205. The support structure 205 shown in Fig. 2 may be a portion of any type of paved way such as a road, a highway, a bicycle route etc.

The photovoltaic units 200 are shown comprising a cylindrical wall 215 and a photovoltaic cell 250 arranged coaxially inside the cylindrical wall 215. The photovoltaic units 200 may be spaced apart at such distances so that the integrity of the support structure is not compromised. Furthermore, they are preferably placed in areas of the support ground where there is minimum or no obstruction to sun light by barriers, buildings or any other fixed construction that may be in the area.

The photovoltaic units 200 are shown arranged adjacent to illumination systems 240 that are distributed along the side of the paved way. An electrical connection 270 is depicted in the form of a subterranean cable. According to other possible implementations, the electrical cable may be external to the support structure. The electrical connection 270 may be used to power the illumination systems 240 or to charge batteries that may form part of the illumination systems or may be placed in the vicinity of the illumination systems or of the photovoltaic units.

The size and scale of the depicted elements shown are only schematic. The size of the photovoltaic unit may be determined in accordance with the support in which it is integrated. Depending on the macrostructure of the asphalt of e.g. a highway, the size of the photovoltaic cell may be varied without causing a noticeable disturbance to passing traffic. Similarly, depending on its application the loads on the photovoltaic cell may vary. It will be clear that loads to withstand are smaller in case of bicycle lane, than in the case of heavy traffic over a highway. In the latter case, the size of the unit may be made small enough, so that in any case it only has to withstand a very small percentage of the load of a truck or lorry for example.

Also, the number of units to be integrated in a paved structure and its concentration (i.e. number of units per unit surface) may be varied in accordance with circumstances. The local energy requirements may be taken into account, as well as the loads to with the units will be submitted.

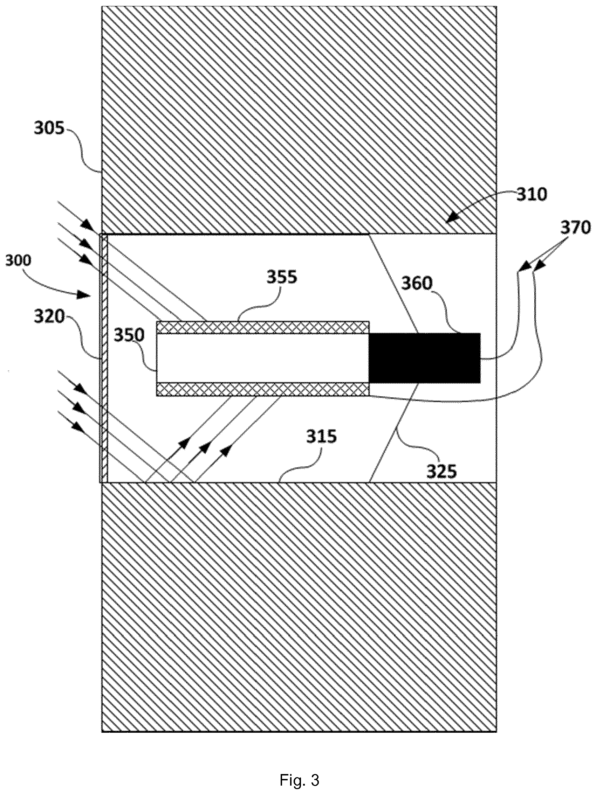

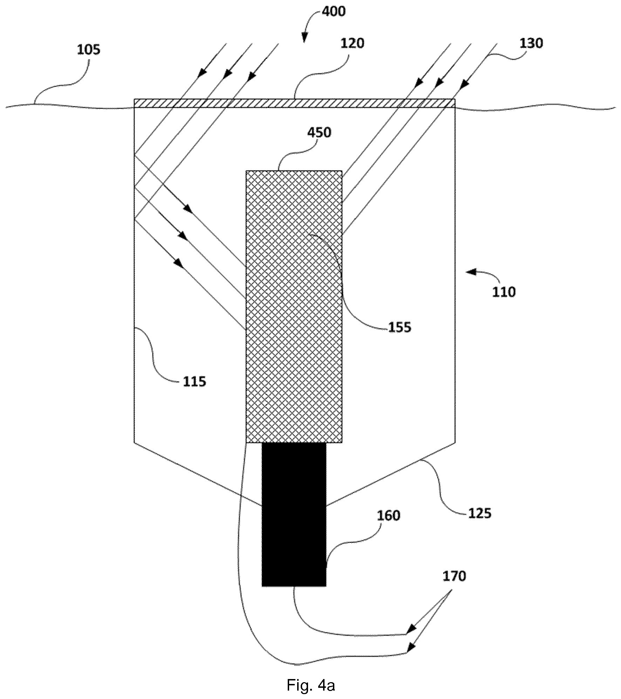

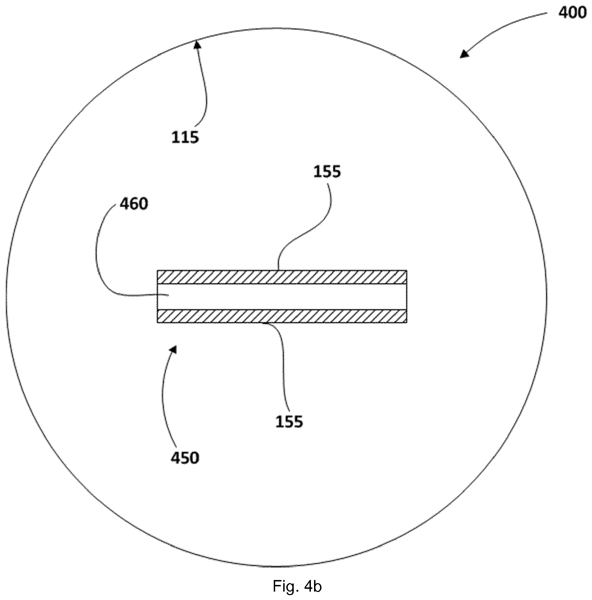

Figure 3 shows a cross-section of a photovoltaic structure according to another embodiment. The photovoltaic unit 300 may be arranged inside a support structure 305. The support structure 305 may be any type of exterior surface of a building or construction such as a wall or a roof. One skilled in the art may appreciate that any type of exterior surface exposed to sun light and used to protect closed areas from sun light may be suitable as a support.

In this particular case, support structure 305 may be assumed to be a vertical side wall. It may be seen that the photovoltaic unit is arranged to be substantially perpendicular to the side wall and thus lies substantially horizontal.

The photovoltaic unit 300 shown in Fig. 3 comprises a housing 310 and a photovoltaic cell 350 arranged along a central axis of housing 300 in a similar manner as that described with reference to Fig. 1. The housing 310 has a substantially cylindrical wall 315 arranged around the central axis of the housing 310. An inner surface of the cylindrical wall 315 is reflective to sun light. The cylindrical wall 315 may be made of reflective material or it may be coated with reflective material. A first end of the housing 310 may be closed with a translucent element 320. The translucent element 320 may be flat and in the form of a cylindrical disc and may be transparent. The closing element protects the photovoltaic cell from any weather phenomena, such as rain or wind.

The translucent element 320 is shown embedded in the support structure in such a way that it is substantially on the same level as the support structure. Therefore, it may even look like a normal window from the outside. The other end of the cylindrical wall 315 is shown closed with a conical closing element 325. The closing element 325 may also be made of or coated with reflective material.

The photovoltaic cell 350 is also substantially cylindrical and comprise an anode 355, a cathode 360 and photoactive material so that any sun light falling on the cell may generate a voltage between the anode and the cathode. The sun-light may fall on the photoactive material either directly, or after being reflected inside the unit. In a similar manner as discussed with reference to Fig. 1, the photovoltaic cell 350 may be made of a thin film solar cell, a dye-sensitized solar cell, an organic photovoltaic cell or a crystalline silicon cell. A pair of electrical output wires 370 is shown connected at one end to the anode 355 and to the cathode 360, respectively. At the other end they may be connected to a battery for charging the battery or directly power some electrical appliance within the building (not shown).

## Claims

1. A photovoltaic unit (100; 200; 300; 400) comprising:
- a housing (110; 310) having a cylindrical wall (115; 315) arranged around a central axis of the housing, a translucent closing element (120; 320) at a first end of the cylindrical wall and a second conical closing element (125; 325) at a second end of the cylindrical wall, wherein the second closing element (125; 325) is at least partially reflective to sun light (130),
- a substantially cylindrical photovoltaic cell (150; 350) arranged along said central axis, comprising an anode (155; 355), a cathode (160; 360) and photoactive material, wherein electrical output wires (170; 370) are connected to the anode (155; 355) and to the cathode (160; 360), and wherein
an inner surface of the cylindrical wall (115; 315) is reflective to sun light.

2. A photovoltaic unit according to claim 1, wherein the translucent closing element (120; 320) is a substantially flat transparent circular disc.

3. A photovoltaic unit according to claim 1 or 2, wherein the photovoltaic cell is a thin film solar cell or a dye-sensitized solar cell or an organic photovoltaic cell or a crystalline silicon cell.

4. A photovoltaic structure comprising a support (105; 305) and one or more photovoltaic units according to any of claims 1 - 3.

5. A photovoltaic structure according to claim 4, wherein the support has a substantially flat external surface, and wherein each photovoltaic unit is arranged such that the translucent closing element lies substantially flush with the flat external surface.

6. A photovoltaic structure according to claim 5, wherein each photovoltaic unit is embedded in the support (105; 305).

7. A photovoltaic structure according to any of claims 4 - 6, wherein the support is a paved structure.

8. A photovoltaic structure according to claim 7, wherein the electrical power output wires of one or more of the photovoltaic units are connected to a metal mesh in the paved structure.

9. A photovoltaic structure according to any of claims 4 - 6, wherein the support is an exterior surface of a building, such as a wall or a roof.

10. A photovoltaic structure according to any of claims 4 - 9, wherein any electrical power generated by the photovoltaic units is stored in accumulators.

11. A photovoltaic structure according to any of claims 4 - 9, wherein any electrical power generated by the photovoltaic units is used for powering one or more electrical systems located adjacent to the photovoltaic structure.

## Patentansprüche

1. Eine photovoltaische Einheit (100; 200; 300; 400) umfassend:
- ein Gehäuse (110; 310), das eine zylindrische Wand (115; 315) hat, die um eine Mittelachse des Gehäuses angeordnet ist, ein transluzentes Verschlusselement (120; 320) an einem Ende der zylindrischen Wand und ein zweites konisches Verschlusselement (125; 325) an einem zweiten Ende der zylindrischen Wand, wobei das zweite Verschlusselement (125; 325) mindestens teilweise das Sonnenlicht reflektiert (130),
- eine im Wesentlichen zylindrische photovoltaische Zelle (150; 350), die entlang der Mittelachse angeordnet ist und eine Anode (155; 355), eine Kathode (160; 360) und photoaktives Material umfasst, wobei elektrische Ausgangsleitungen (170; 370) mit der Anode (155; 355) und mit der Kathode (160; 360) verbunden sind, und wobei
eine innere Oberfläche der zylindrischen Wand (115; 315) das Sonnenlicht reflektiert.

2. Eine photovoltaische Einheit nach Anspruch 1, wobei das transluzente Verschlusselement (120; 320) eine im Wesentlichen flache transparente kreisförmige Scheibe ist.

3. Eine photovoltaische Einheit nach Anspruch 1 oder 2, wobei die photovoltaische Zelle eine Dünnschichtsolarzelle oder eine Farbstoffsolarzelle oder eine organische photovoltaische Zelle oder eine siliciumbasierte kristalline Zelle ist.

4. Eine photovoltaische Struktur umfassend eine Halterung (105; 305) und eine oder mehrere photovoltaische Einheiten nach einem der Ansprüche 1 - 3.

5. Eine photovoltaische Struktur nach Anspruch 4, wobei die Halterung eine im Wesentlichen flache äußere Oberfläche hat, und wobei jede photovoltaische Einheit derart angeordnet ist, dass das transluzente Verschlusselement im Wesentlichen bündig mit der flachen äußeren Oberfläche liegt.

6. Eine photovoltaische Struktur nach Anspruch 5, wobei jede photovoltaische Einheit in der Halterung (105; 305) eingebettet ist.

7. Eine photovoltaische Struktur nach einem der Ansprüche 4 - 6, wobei die Halterung eine gepflasterte Struktur ist.

8. Eine photovoltaische Struktur nach Anspruch 7, wobei die elektrischen Stromausgangsleitungen von einer oder mehreren der photovoltaischen Einheiten mit einem Metallgewebe in der gepflasterten Struktur verbunden sind.

9. Eine photovoltaische Struktur nach einem der Ansprüche 4 - 6, wobei die Halterung eine äußere Oberfläche eines Gebäudes, wie etwa eine Wand oder ein Dach, ist.

10. Eine photovoltaische Struktur nach einem der Ansprüche 4 - 9, wobei jedwede durch die photovoltaischen Einheiten erzeugte elektrische Leistung in Akkumulatoren gespeichert wird.

11. Eine photovoltaische Struktur nach einem der Ansprüche 4 - 9, wobei jedwede durch die photovoltaischen Einheiten erzeugte elektrische Leistung zum Antreiben von einem oder mehreren angrenzend an der photovoltaischen Struktur angeordneten elektrischen Systemen benutzt wird.

## Revendications

1. Une unité photovoltaïque (100 ; 200 ; 300 ; 400) comprenant :
- un boîtier (110 ; 310) ayant une paroi cylindrique (115 ; 315) disposée autour d'un axe central du boîtier, un élément de fermeture translucide (120 ; 320) dans une première extrémité de la paroi cylindrique et un deuxième élément de fermeture conique (125 ; 325) dans une deuxième extrémité de la paroi cylindrique, dans laquelle le deuxième élément de fermeture (125 ; 325) réfléchit au moins en partie la lumière du soleil (130),
- une cellule photovoltaïque essentiellement cylindrique (150 ; 350) disposée le long dudit axe central, comprenant un anode (155 ; 355), un cathode (160 ; 360) et du matériau photoactif, dans laquelle des fils de sortie électrique (170 ; 370) sont reliés avec l'anode (155 ; 355) et avec le cathode (160 ; 360), et
dans laquelle
une surface intérieure de la paroi cylindrique (115 ; 315) réfléchit la lumière du soleil.

2. Une unité photovoltaïque selon la revendication 1, dans laquelle l'élément de fermeture translucide (120 ; 320) est un disque circulaire transparent essentiellement plat.

3. Une unité photovoltaïque selon la revendication 1 ou 2, dans laquelle la cellule photovoltaïque est une cellule solaire à couche mince ou une cellule à pigment photosensible ou une cellule photovoltaïque organique ou une cellule en silicium cristallin.

4. Une structure photovoltaïque comprenant un support (105 ; 305) et une ou plusieurs unités photovoltaïques selon l'une quelconque des revendications 1 - 3.

5. Une structure photovoltaïque selon la revendication 4, dans laquelle le support a une surface extérieure essentiellement plate, et dans laquelle chaque unité photovoltaïque est disposée de façon que l'élément de fermeture translucide est disposé essentiellement de niveau avec la surface extérieure plate.

6. Une structure photovoltaïque selon la revendication 5, dans laquelle chaque unité photovoltaïque est intégrée dans le support (105 ; 305).

7. Une structure photovoltaïque selon l'une quelconque des revendications 4 - 6, dans laquelle le support est une structure pavée.

8. Une structure photovoltaïque selon la revendication 7, dans laquelle les fils de sortie de courant électrique d'une ou plus des unités photovoltaïques sont reliés avec un treillis métallique dans la structure pavée.

9. Une structure photovoltaïque selon l'une quelconque des revendications 4 - 6, dans laquelle le support est une surface extérieure d'un bâtiment, telle qu'une paroi ou un toit.

10. Une structure photovoltaïque selon l'une quelconque des revendications 4 - 9, dans laquelle la puissance électrique générée par les unités photovoltaïques est stockée dans des accumulateurs.

11. Une structure photovoltaïque selon l'une quelconque des revendications 4 - 9, dans laquelle la puissance électrique générée par les unités photovoltaïques est utilisée pour alimenter un ou plusieurs systèmes électriques situés en position adjacente à la structure photovoltaïque.
